(19) Europäisches Patentamt
European Patent Office
Office européen des brevets

(11) **EP 3 360 933 A1**

(12) **EUROPÄISCHE PATENTANMELDUNG**

(43) Veröffentlichungstag:
**15.08.2018 Patentblatt 2018/33**

(51) Int Cl.:
*C09D 1/00* (2006.01)      *C23C 18/14* (2006.01)
*G03F 7/004* (2006.01)

(21) Anmeldenummer: **17155205.2**

(22) Anmeldetag: **08.02.2017**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA MD**

(71) Anmelder: **Evonik Degussa GmbH**
**45128 Essen (DE)**

(72) Erfinder:
- **MERKULOV, Alexey**
  **45772 Marl (DE)**
- **BRENDT, Jochen**
  **93059 Regensburg (DE)**
- **KÖHLING, Jonas**
  **28755 Bremen (DE)**

(54) **DIREKT-STRUKTURIERBARE FORMULIERUNGEN AUF DER BASIS VON METALLOXID-PREKURSOREN ZUR HERSTELLUNG OXIDISCHER SCHICHTEN**

(57) Beschichtungszusammensetzungen umfassend einen Metalloxid-Prekursor, einen Photosäuregenerator und ein Lösemittel. Die vorliegende Erfindung betrifft weiterhin die Verwendung einer solchen Beschichtungszusammensetzung zur Herstellung direkt-strukturierter metalloxidischer Schichten, ein Verfahren zur Herstellung metalloxidischer Schichten unter Verwendung einer solchen Beschichtungszusammensetzung, eine nach einem solchen Verfahren hergestellte Metalloxid-haltige Schicht, sowie die Verwendung einer solchen Metalloxid-haltigen Schicht zur Herstellung elektronischer Bauteile, insbesondere zur Herstellung von Transistoren, Dioden, Sensoren oder Solarzellen.

EP 3 360 933 A1

**EP 3 360 933 A1**

## Beschreibung

Gegenstand der vorliegenden Erfindung sind direkt-strukturierbare Beschichtungszusammensetzungen umfassend einen Metalloxid-Prekursor, einen Photosäuregenerator und ein Lösemittel. Die vorliegende Erfindung betrifft weiterhin die Verwendung einer solchen Beschichtungszusammensetzung zur Herstellung direkt-strukturierter metalloxidischer Schichten, ein Verfahren zur Herstellung metalloxidischer Schichten unter Verwendung einer solchen Beschichtungszusammensetzung, eine nach einem solchen Verfahren hergestellte Metalloxid-haltige Schicht, sowie die Verwendung einer solchen Metalloxid-haltigen Schicht zur Herstellung elektronischer Bauteile, insbesondere zur Herstellung von Transistoren, Dioden, Sensoren oder Solarzellen.

Metalloxidische Schichten sind essentiell für viele Anwendungen, insbesondere im Bereich der Halbleitertechnologie. Metalloxidische Schichten lassen sich durch vielfältige Verfahren auf verschiedene Oberflächen aufbringen. Zu diesen Verfahren zählen Vakuumverfahren (Sputtern, chemische Gasphasenabscheidung) und nasschemische Verfahren. Von diesen haben die nasschemischen Verfahren, die auch als Flüssigphasen-Verfahren bezeichnet werden, den Vorteil, dass sie einen geringeren apparativen Aufwand erfordern. Flüssigphasen-Verfahren können mit dispergierten Nanopartikeln oder mit Prekursor-Systemen durchgeführt werden. Dispergierte Nanopartikel haben dabei den Nachteil, dass ihre Herstellung apparativ aufwändig ist und dass die mit ihnen hergestellten Halbleiter-Schichten oft negative Eigenschaften haben.

Aus diesem Grund wird Flüssigphasen-Beschichtungsverfahren, die Prekursoren einsetzen, oft der Vorzug gegeben. Unter einem Metalloxid-Prekursor ist dabei eine thermisch oder mit elektromagnetischer Strahlung zersetzbare Verbindung, mit der in An- oder Abwesenheit von Sauerstoff oder anderen Oxidationsstoffen Metalloxid-haltige Schichten gebildet werden können, zu verstehen.

Aus Metalloxid-Prekursoren gebildete, Metalloxid-haltige Schichten, die für vielfältige Anwendungen in der Halbleitertechnik von Interesse sind, werden üblicherweise durch den Einsatz von Photolacken strukturiert, die einen erhöhten Materialbedarf, eine Vielzahl an zusätzlichen Prozessschritten und einen zusätzlichen Stress für die Oxid-Schicht durch den Kontakt mit aggressiven Materialien zur Folge haben.

Die direkte Strukturierung Metalloxid-haltiger Schichten macht die Verwendung von Photolacken obsolet. Im Stand der Technik sind vier verschiedene Verfahren für die direkte Strukturierung Metalloxid-haltiger Schichten bekannt. Ein erstes Verfahren (Cordonier et al., Langmuir, 2011, 27 (6), S. 3157-3165) beinhaltet die Verwendung Photosäuregenerierender Liganden für Indiumoxid- und Titanoxid-Prekusoren auf Catechol-Basis. Die photoinduzierte Spaltung des Liganden setzt ein Säuremolekül frei, wodurch im belichteten Bereich gegenüber der übrigen Schicht ein Löslichkeitsunterschied bewirkt wird, der eine Entwicklung als Positivlack ermöglicht. Das beschriebene Verfahren wird durch die Notwendigkeit, Liganden passend zum jeweilig eingesetzten Metalloxid-Prekusor synthetisieren zu müssen, unter praktischen Gesichtspunkten stark eingeschränkt.

Ein zweites Verfahren (Rim et al., ACS Nano, 2014, 8 (9), S. 9680-9686) beschreibt Formulierungen auf Basis von Metallnitraten, die für die Herstellung Metalloxid-haltiger Schichten genutzt und durch Zugabe vom Ammoniumhydroxid und Acetylaceton direkt strukturiert werden können. Das Wirkprinzip beruht auf der Bindung von Acetylacetonat an das Metallzentrum, wodurch ein photosensitiver Metallkomplex entsteht. Durch Bestrahlung wird eine Polymerisation initiiert, die einen Löslichkeitsunterschied gegenüber dem unbelichteten, nicht-polymerisierten Bereich der Beschichtung bewirkt (Negativlack). Die Verwendbarkeit von Metalloxid-Prekursoren wird in diesem Verfahren durch die Notwendigkeit eines Ligandenaustauschs mit Acetylaceton stark limitiert.

Ein weiteres Verfahren (JP 07258866 A) beschreibt eine Formulierung, die eine direkte Strukturierung durch Zugabe von Wasser-freisetzenden Molekülen sowie, optional, Photosäuregeneratoren ermöglicht. Durch Polykondensation, die durch vorherige Freisetzung von Wasser (und optional Säuremolekülen) initiiert wird, wird in belichteten und unbelichteten Bereichen ein Löslichkeitsunterschied bewirkt (Negativlack). In diesem Verfahren können ausschließlich Metalloxid-Prekursoren verwendet werden, die über Polykondensationsreaktionen vernetzbar sind.

Ein letztes im Stand der Technik bekanntes Verfahren für die direkte Strukturierung Metalloxid-haltiger Schichten (DE 102013212018 A1) beschreibt Metalloxid-Prekursoren, die einen phtovernetzbaren Liganden und einen nicht-photovernetzbaren Liganden aufweisen. Ein Löslichkeitsunterschied zwischen belichteten und unbelichteten Bereichen der Beschichtung wird durch Polymerisierung der Liganden bewirkt (Negativlack). Limitierend für entsprechende Verfahren sind die Metalloxid-Prekursoren, welche gezielt durch Ligandenaustausch mit polymerisierbaren Liganden, wie beispielsweise Methacrylsäure, synthetisiert werden müssen.

Es ist somit die Aufgabe der vorliegenden Erfindung, eine Beschichtungszusammensetzung bereitzustellen, die die im Stand der Technik vorhandenen Nachteile zu überwinden vermag.

Diese Aufgabe wird vorliegend gelöst durch eine Beschichtungszusammensetzung umfassend:

    a) mindestens einen Metalloxid-Prekursor,
    b) mindestens einen Photosäuregenerator und
    c) mindestens ein Lösemittel.

In einem weiteren Aspekt richtet sich die vorliegende Erfindung auch auf die Verwendung der wie hierin beschriebenen Beschichtungszusammensetzung zur Herstellung strukturierter metalloxidischer Schichten.

In einem weiteren Aspekt richtet sich die vorliegende Erfindung weiterhin auf ein Verfahren zur Herstellung metalloxidischer Schichten, dadurch gekennzeichnet, dass das Verfahren die folgenden Schritte umfasst:

(I) Beschichtung eines Substrates mit mindestens einer wie hierin beschriebenen Beschichtungszusammensetzung;
(II) Belichtung der so aufgetragenen Beschichtung;
(III) Entwicklung der Beschichtung.

In noch einem Aspekt richtet sich die vorliegende Erfindung auf eine Metalloxid-haltige Schicht, die nach einem wie hierin beschriebenen Verfahren hergestellt wurde.

In einem letzten Aspekt richtet sich die vorliegende Erfindung schließlich auf die Verwendung einer wie hierin beschrieben hergestellten Metalloxid-haltigen Schicht zur Herstellung elektronischer Bauteile, insbesondere zur Herstellung von Transistoren, Dioden, Sensoren oder Solarzellen.

Weitere Aspekte können den angehängten Ansprüchen entnommen werden.

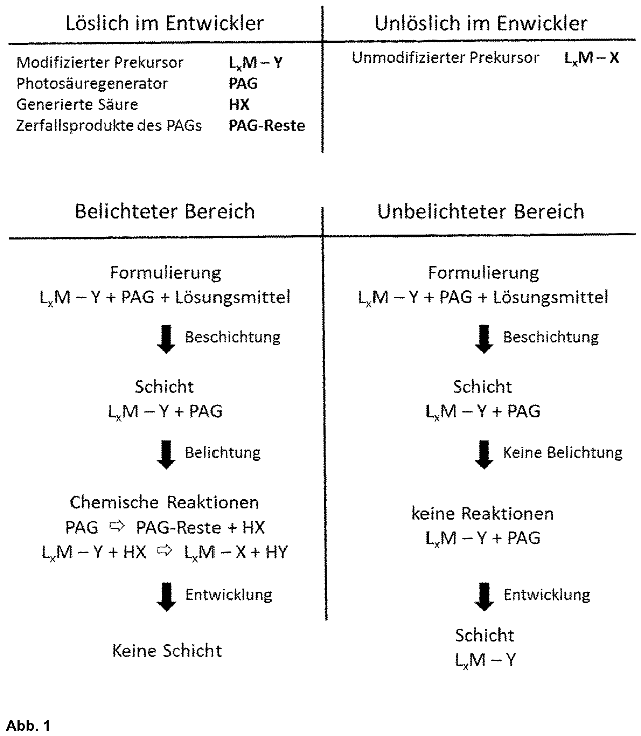

**Abbildung 1** zeigt das schematisch vereinfacht dargestellte Wirkprinzip der erfindungsgemäßen Beschichtungszusammensetzung. Einander gegenübergestellt sind ein Bereich des zu beschichtenden Substrates, welcher im Zuge des wie hierin beschriebenen Verfahrens zur Herstellung einer metalloxidischen Schicht belichtet wird, und ein Bereich des Substrates, welcher nicht belichtet wird. In beiden Bereichen erfolgt zunächst die Beschichtung der erfindungsgemäßen Beschichtungsformulierung. Die so hergestellte Beschichtung umfasst den Metalloxid-Prekursor ("$L_xM$ - X") und den Photosäuregenerator (PAG, *photoacid generator*). Im Zuge der partiellen Belichtung kommt es zu einem photolytischen Zerfall des Photosäuregenerators zu einer Säuremolekül (HX) und den Resten (PAG-Reste). Die dadurch im belichteten Bereich freigesetzten Säuremoleküle reagieren mit dem Metalloxid-Prekursor und bilden im Entwickler-löslichen modifizierten Prekursor ("$L_xM$ - Y") sowie Ligandenaustauschprodukt ("HY"). Im unbelichteten Bereich werden keine Säuremoleküle freigesetzt. Auf diese Weise wird ein Löslichkeitsunterschied der aufgetragenen Beschichtung erwirkt. Im Zuge der Entwicklung werden sämtliche in der Entwicklerlösung löslichen Bestandteile abgetragen. Dadurch kommt es im belichteten Bereich zu einem Abtragen der gesamten Beschichtung, im unbelichteten Bereich hingegen nur zu einem Abtragen des Photosäuregenerators. Das Resultat ist eine Oberflächenstrukturierung, deren Musterbildung der eines Positivlacks entspricht.

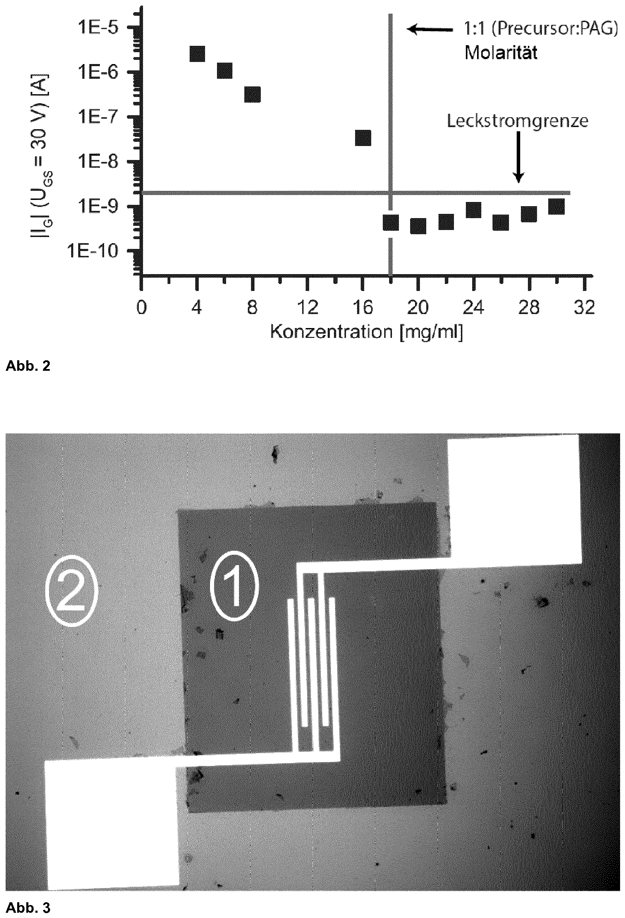

**Abbildung 2** zeigt Leckströme für verschiedene Beschichtungszusammensetzungsformulierungen mit unterschiedlichen Konzentrationen an Photosäuregenerator. Es wird deutlich, dass jene Formulierungen enthaltend den Photosäuregenerator in mindestens äquimolarem Verhältnis zum Metalloxid-Prekursor verbesserte Resultate hinsichtlich auftretender Leckströme erzielen.

**Abbildung 3** zeigt eine Lichtmikroskopaufnahme einer 7 nm dicken direkt-strukturierten Halbleiterschicht in einer TFT (*Thin Film Transistor*) -Struktur. (1) Halbleiterschicht; (2) Substrat.

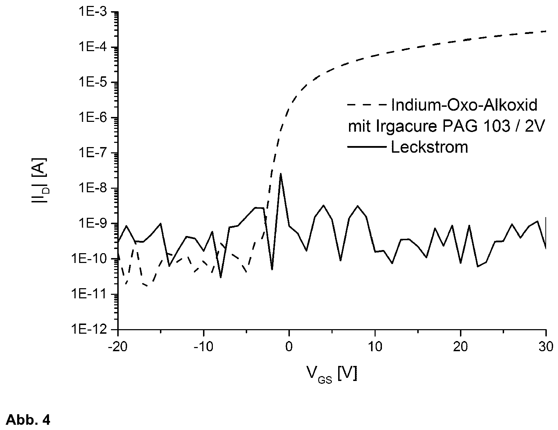

**Abbildung 4** zeigt eine Transferkennlinie für die in Ausführungsbeispiel 1 der vorliegenden Erfindung direkt-strukturierte Halbleiterschicht unter Angabe einer Referenz und des Leckstroms.

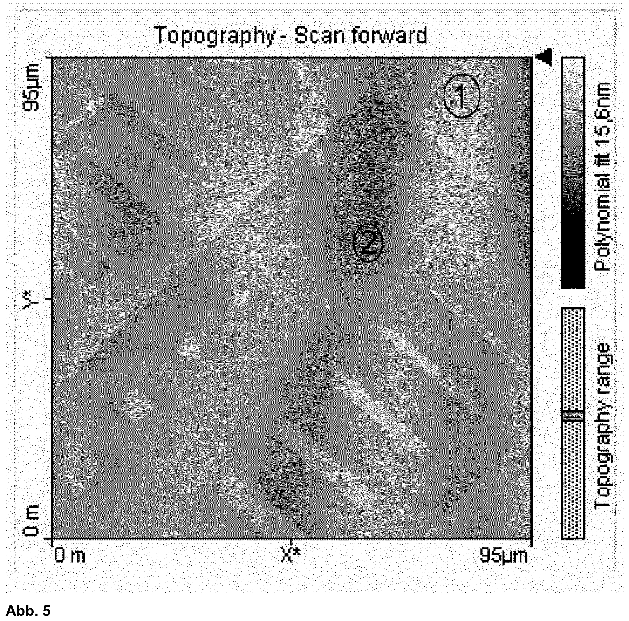

**Abbildung 5** zeigt eine AFM-Messung einer 7 nm dicken, direkt-strukturierten Schicht. (1) Halbleiterschicht; (2) Substrat.

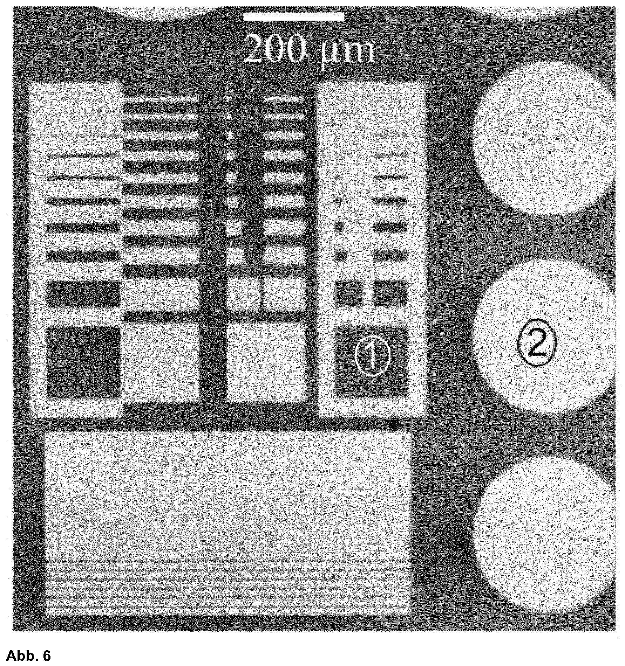

**Abbildung 6** zeigt eine Lichtmikroskopaufnahme von verschiedenen Strukturen von einer in Ausführungsbeispiel 1 direkt-strukturierten Halbleiterschicht. (1) Halbleiterschicht; (2) Substrat.

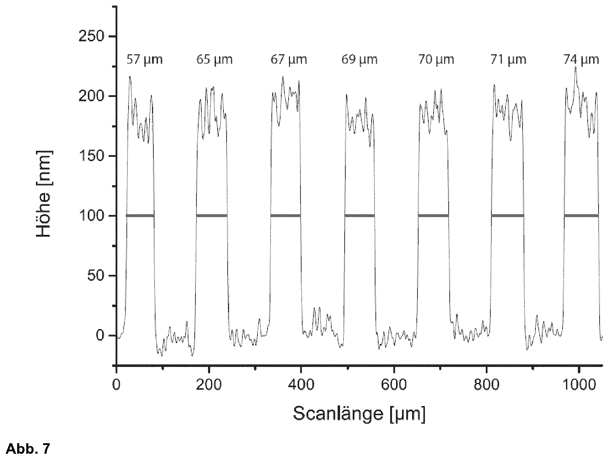

**Abbildung 7** zeigt eine Profilometer-Messung einer 200 nm dicken direkt-strukturierten Halbleiterschicht.

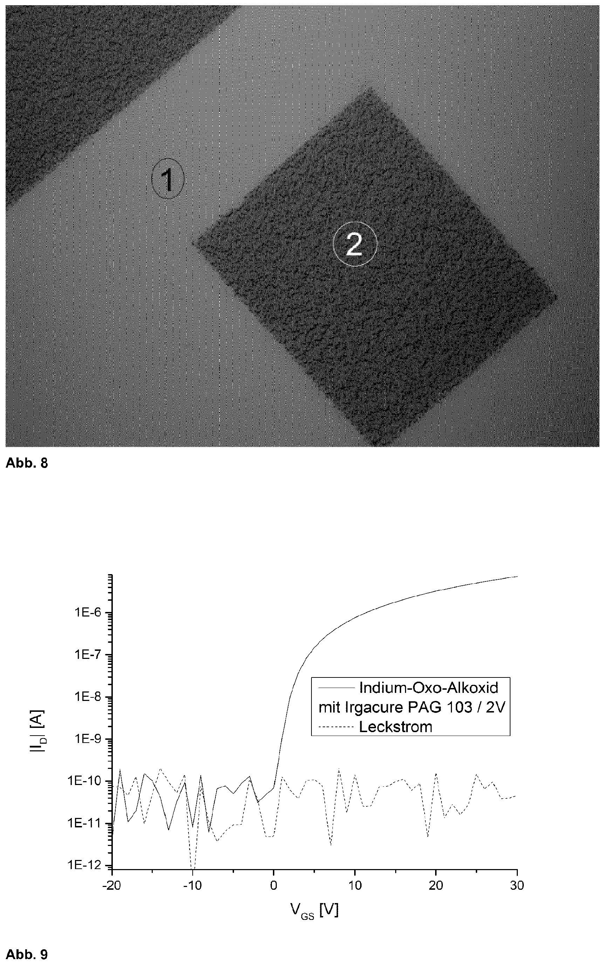

**Abbildung 8** zeigt eine Lichtmikroskopaufnahme von der in Ausführungsbeispiel 2 direkt-strukturierten Halbleiterschicht in einer TFT-Struktur. (1) Substrat; (2) Halbleiterschicht.

**Abbildung 9** zeigt eine Transferkennlinie für die in Ausführungsbeispiel 3 direkt-strukturierte Halbleiterschicht.

"Mindestens ein" wie hierin verwendet, bedeutet 1 oder mehr, d.h. 1, 2, 3, 4, 5, 6, 7, 8, 9 oder mehr. "Mindestens ein Lösemittel" bedeutet somit beispielsweise mindestens eine Art von Lösemittel, d.h. dass eine Art von Lösemittel oder eine Mischung mehrerer verschiedener Lösemittel gemeint sein kann.

"Ungefähr", wie hierin verwendet, bezeichnet einen Bereich von +/- 10 %, vorzugsweise +/- 5 % des jeweiligen angegebenen Wertes.

Die erfindungsgemäßen Beschichtungszusammensetzungen zeichnen sich dadurch aus, dass mindestens ein Metalloxid-Prekursor und mindestens ein Photosäuregenerator als einzelne Komponenten der Zusammensetzung direkt kombiniert miteinander formuliert werden. Gemäß der vorliegenden Erfindung handelt es sich bei dem mindestens einen Photosäuregenerator nicht um einen Liganden des Metalloxid-Prekursors, d.h. zu keinem Zeitpunkt innerhalb der Prozessabfolge besteht eine Bindung zwischen dem Photosäuregeneratormolekül und dem Metalloxid-Prekursor. Beide Komponenten liegen in einem oder mehreren geeigneten Lösemitteln gelöst vor. Durch eine solch einfache Kombination eines Prekursors und eines Photosäuregenerators ist eine aufwändige Synthese geeigneter Liganden und der entsprechenden Metallkomplexe überflüssig. Die erfindungsgemäßen Formulierungen können somit der jeweiligen Anwendung entsprechend einfacher und spezifischer angepasst werden. Darüber hinaus können für die Entwicklung der Strukturen eine Vielzahl von Entwicklerlösemitteln verwendet werden. Auch der Einsatz wassersensitiver Stoffe ist möglich, da auf wässrige Lösungen verzichtet werden kann.

Gegenüber dem Stand der Technik ergeben sich die folgenden Vorteile:

- Bereits bekannte Prekursoren können unverändert eingesetzt werden. Eine aufwendige Synthese spezieller Liganden und Metallkomplexe entfällt. Die Prekursoren müssen weder hydrolytisch polymerisierbar sein, noch muss ein Ligandenaustausch mit Acetylaceton möglich sein.
- Durch die Wahl des Photosäuregenerators kann der Wellenlängenbereich, für den die Formulierung sensitiv ist, gezielt gewählt werden.
- Somit wird ein universeller Einsatz durch vielfältige Kombinationsmöglichkeiten zwischen Prekursor und Photosäuregenerator (und Entwickler) ermöglicht.
- Eine direkte Strukturierung dieser Formulierung ist mit wenigen Prozessschritten möglich, wodurch neben Ressourcen auch Zeit eingespart werden kann und eine erhöhte Prozesszuverlässigkeit gegeben ist.

Ein erster Gegenstand der vorliegenden Erfindung ist daher eine Beschichtungszusammensetzung umfassend mindestens einen Metalloxid-Prekursor, mindestens einen Photosäuregenerator und mindestens ein Lösemittel. Die wie hierin beschriebene Zusammensetzung ist dadurch gekennzeichnet, dass der mindestens eine Metalloxid-Prekursor und der mindestens eine Photosäuregenerator nicht im Bindungsverhältnis zueinander stehen.

Gemäß einer Ausführungsform zeichnet sich die erfindungsgemäße Beschichtungszusammensetzung dadurch aus, dass der Metalloxid-Prekursor mindestens ein Metallatom ausgewählt aus der Gruppe bestehend aus In, Zn, Ga, Y, Sn, Ge, Sc, Ti, Zr, Al, W, Mo, Ni, Cr, Fe, Hf und Cu umfasst. In bevorzugten Ausführungsformen umfasst der mindestens eine Metalloxid-Prekursor mindestens ein Metall ausgewählt aus der Gruppe bestehend aus In, Ga, Ge, Sn, Y und Zn.

Unter einem "Metallatom" ist im Sinne der vorliegenden Erfindung entsprechend sowohl ein Metallatom als auch ein Halbmetallatom zu verstehen. Gleiches gilt für die "Metalloxide", bzw. "Metalloxid-haltigen Schichten", die mit ihnen hergestellt werden können.

Gemäß einer Ausführungsform zeichnet sich die erfindungsgemäße Beschichtungszusammensetzung weiterhin dadurch aus, dass der mindestens ein Metalloxid-Prekursor mindestens einen Liganden ausgewählt aus der Gruppe bestehend aus Oxo-Resten, Hydroxyl-Resten, Alkoxy-Resten, Carboxy-Resten, β-Diketonat-Resten, Halogenid-Resten, Nitrat-Resten und sekundären und primären Amin-Resten umfasst.

Ein erster Vorteil der wie hierin beschriebenen Beschichtungszusammensetzungen und ihrer Verwendung besteht darin, dass bereits im Stand der Technik bekannte und geläufig verwendete Metalloxid-Prekursoren eingesetzt werden können.

Im Kontext der vorliegenden Erfindung können beispielsweise, ohne Einschränkung, insbesondere Metalloxid-Prekursoren ausgewählt aus der Gruppe bestehend aus $[In_6O(OMe)_{12}Cl_6][NH_2Me_2]_2(MeOH)_2$, $Ga(acac)_3$, $Y_5O(O^iPr)_{13}$, $Ge(O^iPr)_4$, $In(NO_3)_3$, $InCl_3$, $Sn(O^tBu)_4$ und $Zn(acac)_2$ vorteilhaft eingesetzt werden.

Generell gelten für die im Kontext der vorliegenden Erfindung verwendbaren Metalloxid-Prekursoren keine besonderen Limitierungen, solange sie mindestens einen Liganden aufweisen, welcher von der Prekursor-Verbindung durch eine säure Abspaltung modifiziert werden kann. Auf diese Weise kann ein Löslichkeitsunterschied zwischen einer intakten Metalloxid-Prekursor-Beschichtung und einer nicht-intakten, d.h. sauer gespaltenen Metalloxid-Prekursor-Beschichtung herbeigeführt werden.

Der vorgenannte Effekt wird erfindungsgemäß durch den Einsatz mindestens eines Photosäuregenerators in der wie hierin beschriebenen Beschichtungszusammensetzung herbeigeführt. Im Kontext der vorliegenden Erfindung handelt es sich bei einem Photosäuregenerator um eine Verbindung, welche unter Einwirkung elektromagnetischer Strahlung, insbesondere UV-Licht, ein oder mehrere Säuremoleküle freisetzt. Gemäß der vorliegenden Erfindung kann es sich bei einem solchen Säuremolekül um eine organische oder anorganische (mineralische) Säure handeln. Beispiele für organische Säuren schließen ein, sind aber nicht beschränkt auf, Carbonsäuren, Sulfonsäuren und Phosphonsäuren. Beispiele für Mineralsäuren schließen ein, sind aber nicht beschränkt auf, Salzsäure, Flusssäure, Phosphorsäure, Schwefelsäure und Salpetersäure. Unter den Begriff Säuremolekül fallen im Kontext der vorliegenden weiterhin anorganische Salze, welche in protischer Lösung Mineralsäuremoleküle bilden. Beispielhaft seien in diesem Zusammenhang, ohne Einschränkung, $PF_4^-$ und $BF_4^-$ genannt.

Gemäß einer Ausführungsform zeichnet sich die wie hierin beschriebene Beschichtungszusammensetzung folglich dadurch aus, dass der mindestens eine Photosäuregenerator unter Einwirkung von elektromagnetischer Strahlung in der Lage ist, Säuremoleküle freizusetzen. Dabei kann es sich bei einem Photosäuregenerator gemäß der vorliegenden Erfindung um eine ionische oder nicht-ionische Verbindung handeln.

Generell geeignet sind im Kontext der vorliegenden Erfindung alle Photosäuregeneratoren, welche die vorgenannten Kriterien erfüllen. Beispielhaft seien in diesem Zusammenhang, ohne Einschränkung, insbesondere Photosäuregeneratoren ausgewählt aus der Gruppe bestehend aus (Z)-[2-(Propylsulfonyloxyimino)-3-thienyliden](o-tolyl)acetonitril), Triphenylsulfoniumtriflat, Diphenyliodoniumnitrat, 1-Hydroxycyclohexylphenylketon, 2-Hydroxy-2-methyl-1-phenyl-1-propanon, 2-Hydroxy-1-[4-(2-hydroxyethoxy)phenyl]-2-methyl-1-propanon, Methylbenzoylformiat, Oxyphenylessigsäure-2-[2-oxo-2-phenylacetoxyethoxy]ethylester, Oxyphenylessigsäure-2-[2-hydroxy-ethoxy]ethylester, 2,2-Dimethoxy-2-phenylacetophenon, 2-Benzyl-2-(dimethylamino)-1-[4-(4-morpholinyl)phenyl]-1-butanon, 2-Methyl-1-[4-(methylthio)phenyl]-2-(4-morpholinyl)-1-propanon, Diphenyl(2,4,6-trimethylbenzoyl)phosphinoxid, Bis(2,4,6-trimethylbenzoyl)phenylphosphinoxid sowie Mischungen der vorgenannten genannt. Generell sind sämtliche im Stand der Technik bekannten und kommerziell erhältlichen Photosäuregeneratoren für die Verwendung in Beschichtungszusammensetzungen gemäß der vorliegenden Erfindung geeignet.

Das Wirkprinzip der erfindungsgemäßen Beschichtungsformulierungen beruht auf der photoinduzierten Abspaltung von ein oder mehreren Säuremolekülen durch mindestens einen Photosäuregenerator. Gemäß der vorliegenden Erfindung sind Photosäuregenerator und Metalloxid-Prekursor miteinander kombiniert in der erfindungsgemäßen Beschichtungszusammensetzung formuliert, liegen allerdings nicht im Bindungsverhältnis zueinander, d.h. liegen als separate Moleküle in der Beschichtungszusammensetzung vor. Nachdem die Beschichtungszusammensetzung auf die zu beschichtende Oberfläche aufgetragen wurde, reagieren im Zuge einer nachfolgend durchgeführten Belichtung abgespaltene Säuremoleküle mit den in der aufgetragenen Beschichtung enthaltenden Metalloxid-Prekursoren, dies jedoch ausschließlich im belichteten Bereich. Durch Einwirkung der Säuremoleküle auf dem Metalloxid-Prekursor wird ein Löslichkeitsunterschied zwischen belichteten und unbelichteten Bereichen der aufgetragenen Beschichtung erwirkt, wobei die Löslichkeit in belichteten Bereichen gegenüber der Löslichkeit in unbelichteten Bereichen signifikant erhöht ist. Ein signifikanter Unterschied der Löslichkeit der aufgetragenen Beschichtung in belichteten und unbelichteten Bereichen ist gemäß der vorliegenden Erfindung dann erwirkt, wenn sich die Beschichtung im belichteten Bereich unter Einwirkung einer Entwicklerlösung vollständig lösen und abtragen lässt, die Beschichtung im unbelichteten Bereich unter Einwirkung selbiger Entwicklerlösung jedoch intakt verbleibt. Auf diese Weise kann gemäß der vorliegenden Erfindung eine direkte Strukturierung der Beschichtungsoberfläche erfolgen. Gemäß der vorliegenden Erfindung entspricht das im Zuge einer erfindungsgemäßen direkten Strukturierung erzielte Beschichtungsmuster einem Positivlack.

Lösemittel, die für die Verwendung in den wie hierin beschriebenen Beschichtungszusammensetzungen geeignet sind, werden vorzugsweise ausgewählt aus der Gruppe bestehend aus β-Diketonen, Etheralkoholen und deren Derivaten wie Ester, Alkoholen, Ethern und Estern, Nitrile. Gemäß der vorliegenden Erfindung kann die erfindungsgemäße Beschichtungszusammensetzung ein einziges Lösemittel oder eine Mischung aus zwei oder mehreren Lösemitteln umfassen. Als besonders geeignete Beispiele im Kontext der vorliegenden Erfindung verwendbarer Lösemittel seien, ohne als Einschränkung verstanden werden zu wollen, N-Methyl-2-pyrrolidon, Ethanol, Methanol, 2-Propanol, 1-Butanol, 1-Cyclohexanol, 1-Methoxy-2-propanol, 2-Ethoxyethanol, 2-Butoxyethanol, 2-(2-Methoxyethoxy)ethanol, Ethyllactat, Butyllactat Tetrahydrofurfurylalkohol, Acetylaceton, Ethylacetat, Acetonitril und Acetylaceton genannt.

Gemäß einigen Ausführungsformen enthalten erfindungsgemäße Beschichtungszusammensetzungen den mindestens einen Metalloxid-Prekursor, wie voranstehend definiert, in Massenkonzentrationen von ungefähr 5 mg/ml bis ungefähr 50 mg/ml, vorzugsweise ungefähr 5 mg/ml bis ungefähr 30 mg/ml, insbesondere ungefähr 5 mg/ml bis ungefähr 25 mg/ml, am meisten bevorzugt ungefähr 7 mg/ml bis ungefähr 25 mg/ml. Selbstverständlich ergeben sich in Abhängigkeit von der Art des jeweiligen zu verwendenden Metalloxid-Prekursors unterschiedliche Konzentrationsbereiche, innerhalb derer die gewünschte Beschichtung vorteilhaft erzeugt werden kann.

Gemäß einigen Ausführungsformen enthalten erfindungsgemäße Beschichtungszusammensetzung den mindestens einen Photosäuregenerator, wie voranstehend definiert, in Massenkonzentrationen von ungefähr 1 mg/ml bis ungefähr 60 mg/ml, vorzugsweise ungefähr 1,5 mg/ml bis ungefähr 55 mg/ml, insbesondere ungefähr 2 mg/ml bis ungefähr 55 mg/ml.

Gemäß einigen Ausführungsformen werden der mindestens eine Metalloxid-Prekursor und der mindestens eine Photosäuregenerator in einem solchen molaren Verhältnis zueinander eingesetzt, dass der mindestens eine Photosäuregenerator, bezogen auf die unter Einwirkung von elektromagnetischer Strahlung freisetzbaren Säuremoleküle, im mindestens äquimolaren Verhältnis zu dem mindestens einen Metalloxid-Prekursor in der wie hierin beschriebenen Zusammensetzung enthalten ist. So ergibt sich für einen Photosäuregenerator, welcher pro Mol Photosäuregeneratormoleküle ein Mol Säuremolekül freisetzt und in einer Konzentration von 10 mol/l in der Beschichtungszusammensetzung enthalten ist, eine Konzentration von 10 mol/l für den jeweiligen Metalloxid-Prekursor. Für einen Photosäuregenerator, welcher hingegen pro Mol Photosäuregeneratormoleküle zwei Mol Säuremoleküle freisetzt, ergibt sich, bei einer Konzentration von 10 mol/l, eine Konzentration von 20 mol/l für den jeweiligen Metalloxid-Prekursor.

Gemäß einigen Ausführungsformen werden der mindestens eine Metalloxid-Prekursor und der mindestens eine Photosäuregenerator in einem solchen molaren Verhältnis zueinander eingesetzt, dass der mindestens eine Photosäuregenerator, bezogen auf die unter Einwirkung von elektromagnetischer Strahlung freisetzbaren Säuremoleküle, im äquimolaren Verhältnis zu dem mindestens einen Metalloxid-Prekursor in der wie hierin beschriebenen Zusammensetzung enthalten ist.

Gemäß einigen Ausführungsformen der vorliegenden Erfindung kann eine wie hierin beschriebene Beschichtungszusammensetzung neben dem mindestens einen Metalloxid-Prekursor, dem mindestens einen Photosäuregenerator und dem mindestens einen Lösemittel weitere Additive umfassen. Generell eignen sich sämtliche gängigen Additive für Beschichtungszusammensetzungen zur Herstellung metalloxidischer Schichten. In diesem Zusammenhang seien beispielhaft, ohne Einschränkung, Tenside und Schauminhibitoren genannt.

Gegenstand der vorliegenden Erfindung ist weiterhin die Verwendung der wie hierin beschriebenen Beschichtungszusammensetzung zur Herstellung direkt-strukturierter metalloxidischer Schichten.

Des Weiteren richtet sich die vorliegende Erfindung auch auf ein Verfahren zur Herstellung metalloxidischer Schichten. Gemäß der vorliegenden Erfindung umfasst das Herstellungsverfahren die folgenden Schritte:

In einem ersten Schritt (Schritt (I)) des erfindungsgemäßen Verfahrens erfolgt die Beschichtung eines Substrates mit mindestens einer wie hierin beschriebenen Beschichtungszusammensetzung. Geeignete Beschichtungsverfahren können dabei beispielsweise, ohne Einschränkung, ausgewählt werden aus der Gruppe bestehend aus Druckverfahren, Sprühverfahren, Rotationsbeschichtungsverfahren, Tauchverfahren und Verfahren ausgewählt aus Meniscus Coating, Slit Coating, Slot-Die Coating und Curtain Coating. Erfindungsgemäße Herstellungsverfahren können einen oder mehrere, sukzessive hintereinander durchgeführte Beschichtungsschritte, wie voranstehend definiert, umfassen. Durch wiederholtes Auftragen können Beschichtungen mit erhöhter Schichtdicke erzielt werden.

Um die Beschichtungsqualität zu verbessern kann an dieser Stelle eine optionale thermische Behandlung eingeführt werden, wie es aus der Stand der Technik für Photolacke bekannt ist. Eine Behandlung bei den Temperaturen zwischen 50°C und 150°C für den Zeitraum zwischen 10 sec und 5 min kann den Schichtkontrast verbessern.

In einem sich der Beschichtung anschließenden Schritt (Schritt (II)) erfolgt die Belichtung der so aufgetragenen Beschichtung. Die Belichtung kann über im Stand der Technik für diesen Zweck bekannte und geläufige Verfahren erfolgen. Gemäß einigen Ausführungsformen zeichnet sich das erfindungsgemäße Herstellungsverfahren dadurch aus, dass die Belichtung mittels Bestrahlung mit UV-, IR- oder VIS-Strahlung erfolgt. In diesem Zusammenhang besonders geeignet sind Belichtungsverfahren, in denen elektromagnetische Strahlung mittels Halogen-Lampen, Niederdruck-Quecksilberdampflampen, insbesondere Quarzglas-Niederdruck-Quecksilberlampen, oder durch einen Excimer über eine geeignete Belichtungsmaske auf die zu belichtenden Bereiche der Beschichtung einwirken kann. Dauer, Bestrahlungsdosis sowie Wellenlänge werden dabei in Abhängigkeit des jeweiligen verwendeten Photosäuregenerators gewählt und angepasst. Hinsichtlich des jeweiligen in der Beschichtungszusammensetzung verwendeten Metalloxid-Prekursors besteht in Hinblick auf Bestrahlungsdauer, -dosis sowie -wellenlänge des Belichtungsschritts keine Abhängigkeit.

In einigen Ausführungsformen erfolgt die in Schritt (II) erfolgende elektromagnetische Bestrahlung dabei mit Strahlung einer Wellenlänge im Bereich von $\lambda$ = 100-500 nm.

In einigen Ausführungsformen erfolgt die in Schritt (II) erfolgende elektromagnetische Bestrahlung über einen Zeitraum von ungefähr 10 Sekunden bis ungefähr 5 Minuten, vorzugsweise ungefähr 10 Sekunden bis ungefähr 3 Minuten, insbesondere ungefähr 10 Sekunden bis ungefähr 120 Sekunden.

Gemäß einigen Ausführungsformen zeichnet sich das erfindungsgemäße Verfahren weiterhin dadurch aus, dass der Photosäuregenerator der Beschichtungszusammensetzung im Zuge der Belichtung in Schritt (II) Säuremoleküle freisetzt, die die Löslichkeit der Beschichtung ändern, wie voranstehend erläutert.

Um die Wirkung der Säuremoleküle zu verbessern kann an dieser Stelle eine optionale thermische Behandlung eingeführt werden, wie es aus der Stand der Technik für Photolacke bekannt ist. Eine Behandlung bei den Temperaturen zwischen 50°C und 150°C für den Zeitraum zwischen 10 sec und 5 min kann den Schichtkontrast verbessern.

In einem nächsten, sich der Belichtung anschließenden Schritt (Schritt (III)) erfolgt die Entwicklung der Beschichtung. Gemäß der vorliegenden Erfindung erfolgt die Entwicklung durch Behandlung der Beschichtung mit einer Entwicklerlösung. In einigen Ausführungsformen erfolgt die Entwicklung durch Behandlung mit mindestens einem Lösemittel ausgewählt aus der Gruppe bestehend aus wässrigen Basen, wässrigen Säuren, Wasser, Alkoholen, Glykolen, Ketonen, Estern sowie Mischungen der vorgenannten. Gemäß einigen Ausführungsformen ist die Entwicklerlösung ausgewählt aus der Gruppe bestehend aus Ethanol, Propanol, 1-Methoxy-2-propanol und Mischungen der vorgenannten. Vorzugsweise handelt es sich bei der in Schritt (III) des erfindungsgemäßen Verfahren einzusetzenden Entwicklerlösung um Ethanol, Dimethylsuccinat, Ethylenglykol und DMSO.

Gemäß einigen Ausführungsformen zeichnet sich das erfindungsgemäße Herstellungsverfahren weiterhin dadurch aus, dass das Verfahren ferner einen Schritt der thermischen Konvertierung (Tempern) der entwickelten Beschichtung umfasst (Schritt IV). Eine thermische Konvertierung gemäß Schritt (IV) erfolgt vorzugsweise bei Temperaturen größer als 300 °C, insbesondere bei 350 °C. Die Dauer einer solchen thermischen Konvertierung liegt dabei gemäß einigen Ausführungsformen im Bereich von ungefähr 30 Minuten bis ungefähr 90 Minuten, beispielsweise bei 60 Minuten.

Ebenfalls möglich ist eine Konvertierung mit elektromagnetischer Bestrahlung. Geeignete elektromagnetische Konvertierungsverfahren und -parameter sind im Stand der Technik bekannt und richten sich nach der Art der jeweiligen metalloxidischen Schicht.

Gemäß einigen Ausführungsformen erfolgt die Konvertierung der Beschichtung in Anwesenheit von Sauerstoff und/oder anderen Oxidationsstoffen, vorzugsweise jedoch in Anwesenheit von Sauerstoff.

Gegenstand der vorliegenden Erfindung ist darüber hinaus auch eine Metalloxid-haltige Schicht, welche nach einem wie hierin beschriebenen Verfahren hergestellt wurde.

In einem letzten Aspekt schließlich richtet sich die vorliegende Erfindung auch auf die Verwendung mindestens einer solchen Metalloxid-haltigen Schicht zur Herstellung elektronischer Bauteile, insbesondere zur Herstellung von Transistoren, insbesondere Dünnschichttransistoren (TFTs), Dioden, Sensoren oder Solarzellen. TFTs können vorteilhaft zur aktiven Streuung von Pixeln in LCDs eingesetzt werden. Eine andere Anwendung sind Schaltkreise aus TFTs, z.B. zur Realisierung von RFID-Etiketten.

Alle zitierten Dokumente sind hierin in ihrer Gesamtheit durch Bezugnahme eingeschlossen. Weitere Ausführungsformen finden sich in den folgenden Beispielen, ohne dass die Erfindung auf diese beschränkt ist.

Es ist selbstverständlich und beabsichtigt, dass alle Ausführungsformen die hierin im Zusammenhang mit den beschriebenen Verbindungen offenbart sind, in gleichem Maße auf die beschriebenen Verwendungen und Verfahren anwendbar sind und umgekehrt. Derartige Ausführungsformen fallen daher ebenfalls in den Umfang der vorliegenden Erfindung.

Die nachfolgenden Beispiele sollen den Gegenstand der vorliegenden Erfindung näher erläutern, ohne dabei einschränkend zu wirken.

Beispiele

Herstellung einer erfindungsgemäßen Beschichtungszusammensetzung: Der Metalloxid-Prekursor wird in einer definierten Konzentration eingewogen und über Nacht durch Rühren (optional durch Erhitzen) in einem oder mehreren Lösemitteln gelöst. Die so erhaltene Formulierung wird durch einen PTFE-Filter filtriert. Der ausgewählte Photosäuregenerator wird eingewogen und in der Formulierung (optional mit Ultraschall) gelöst und optional durch einen PTFE-Filter filtriert.

**Beispiel 1:** Herstellung einer Indium-Oxo-Alkoxid-Beschichtung, Spin-Coating-Beschichtung Basis Halbleiter, Oximsulfonat (nicht ionisch) als Photosäuregenerator, über Spin-Coating beschichtet, im Maskaligner belichtet und mit Ethanol entwickelt. Nach der Entwicklung wurde die Probe durch UVO und Temperatur in den Halbleiter überführt.

Formulierung: Als Prekursor wurde $[In_6O(OMe)_{12}Cl_6][NH_2Me_2]_2(MeOH)_2$, als Photosäuregenerator wurde (Z)-[2-(Propylsulfonyloxyimino)-3-thienyliden](o-tolyl)acetonitril) (Irgacure® PAG 103) und als Lösemittel wurde 1-Methoxy-2-propanol/EtOH (3:1) verwendet. Die Konzentration in Bezug auf den Prekursor betrug 25 mg/ml, Photosäuregenerator betrug 16 mg/ml

Beschichtung Spin-Coating: Volumen 100 $\mu$l/cm$^2$, Rotationsgeschwindigkeit 3000 rpm; Rotationsdauer 30 s.

Strukturierung: Belichtungszeit 3 min; Ethanol als Entwickler; Entwicklungszeit 15 s.

Weitere Prozessierung: UV/O-Behandlung für 10 min; Tempern bei 350 °C für 60 min.

**Beispiel 1b:** Wie Beispiel 1, aber der Spin-Coating-Schritt wurde siebenmal anstatt einmal durchgeführt. Die dickeren Schichten können mit dem Lichtmikroskop und dem Profilometer besser charakterisiert werden.

**Beispiel 1c:** Wie Beispiel 1, aber die Konzentration für Prekursor betrug 50 mg/mL, für PAG 60 mg/mL

**Beispiel 2:** Herstellung einer Indium-Oxo-Alkoxid-Beschichtung, Spin-Coating-Beschichtung Basis Halbleiter, Triphenylsulfoniumtriflat (ionisch) als Photosäuregenerator, über Spin-Coating beschichtet, in der UVO-Box belichtet und mit Ethanol entwickelt. Nach der Entwicklung wurde die Probe durch UVO und Temperatur in den Halbleiter überführt.

Formulierung: Als Prekursor wurde $[In_6O(OMe)_{12}Cl_6][NH_2Me_2]_2(MeOH)_2$, als Photosäuregenerator wurde Triphenylsulfoniumtriflat (Ph3S+CF3SO3-) und als Lösemittel wurde 1-Methoxy-2-propanol/EtOH (3:1) mit 3% Vol. Tetrahydrofurfurylalkohol verwendet. Die Konzentration in Bezug auf den Prekursor betrug 12,5 mg/ml.

Beschichtung Spin-Coating: Volumen 100 $\mu$l/cm$^2$, Rotationsgeschwindigkeit 3000 rpm; Rotationsdauer 30 s.

Strukturierung: Belichtungszeit 1 min; Ethanol als Entwickler; Entwicklungszeit 15 s.

Weitere Prozessierung: UV/O-Behandlung für 10 min; Tempern bei 350 °C für 60 min.

**Beispiel 3:** Herstellung einer Indium-Alkoxid-Beschichtung, Slot-Die-Beschichtung Basis Halbleiter, Oximsulfonat (nicht ionisch) als Photosäuregenerator, über Slot-Die beschichtet, in der ghi-Box belichtet und mit Ethanol entwickelt. Nach der Entwicklung wurde die Probe durch UVO und Temperatur in den Halbleiter überführt. Beispiel 3 stellt ein Beispiel für eine Alternativmethode zu Spin-Coating-basierten Verfahren dar.

Formulierung: Als Prekursor wurde [In$_6$O(OMe)$_{12}$Cl$_6$][NH$_2$Me$_2$]$_2$(MeOH)$_2$, als Photosäuregenerator wurde Irgacure® PAG 103 und als Lösemittel wurde 1-Methoxy-2-propanol/EtOH (3:1) verwendet. Die Konzentration in Bezug auf den Prekursor betrug 25 mg/ml.

Beschichtung Slot-Die: Shim 80 μm, Coating gap betrug 100 μm; die Dicke des Nassfilms betrug 5,5 μm; die Beschichtungsgeschwindigkeit betrug 16,6 mm/s.

Strukturierung: Belichtungszeit 3 min; Ethanol als Entwickler; Entwicklungszeit 15 s.

Weitere Prozessierung: UV/O-Behandlung für 10 min; Tempern bei 360 °C für 60 min.

Die elektrische Charakterisierung erfolgte nach Herstellung einer TFT-Vorrichtung mit einem 4156C Precision Semiconductor Parameter Analyzer von Agilent. Die Proben wurden unter Stickstoffatmosphäre bei Raumtemperatur vermessen. Die Charakterisierung fand im Anschluss an die Temperaturbehandlung statt. Dabei wurden die (vorstrukturierten) Gate-, Source- und Drain-Kontakte mit dem Gerät über Wolfram-Messspitzen verbunden. Zwischen Gate- und Source-Elektrode wurde ein Spannungsprofil zwischen -20 und +30 V durchfahren und der zwischen Source- und Drain-Elektrode fließende Strom aufgezeichnet. Mit Hilfe dieser Daten lassen sich die Mobilitätswerte gemäß

$$\mu_{lin} = \frac{\partial I_D}{\partial V_G} \frac{L}{W C_i V_D}$$

$$\mu_{sat} = \frac{2L}{W C_i} \left( \frac{\partial \left( \sqrt{I_D} \right)}{\partial V_G} \right)^2$$

berechnen, wobei ID und VG der Strom zwischen Drain und Source bzw. die am Gate angelegte Spannung ist. L und W entsprechen der Länge bzw. der Weite des Kanals und Ci ist die Dielektrizitätskonstante des Dielektrikums. Je höher der Wert für die Mobilität, desto besser ist das Material.

**Beispiel 4:** Die Universalität der Erfindung wurde anhand unterschiedlicher Prekursoren und PAGs überprüft. Die Formulierung und Prozessierung wurde analog zum Beispiel 1 durchgeführt, die jeweiligen Konzentrationen und verwendete Stoffe sind in der Tabelle 1 aufgelistet. In diesen Fällen wurde die erfolgreiche Strukturierbarkeit nur optisch mittels Lichtmikroskop nachgewiesen.

**Tabelle 1**

| Precursor | Konzentration Precursor [mg/ml] | Verwendeter PAG | Konzentration Precursor [mg/ml] |
|---|---|---|---|
| [In$_6$O(OMe)$_{12}$Cl$_6$][NH$_2$Me$_2$]$_2$(MeOH)$_2$ | 12.5 | Irgacure® PAG 103 | 18 |
| [In$_6$O(OMe)$_{12}$Cl$_6$][NH$_2$Me$_2$]$_2$(MeOH)$_2$ | 25 | Irgacure® PAG 103 | 36 |
| [In$_6$O(OMe)$_{12}$Cl$_6$][NH$_2$Me$_2$]$_2$(MeOH)$_2$ | 37.5 | Irgacure® PAG 103 | 54 |
| [In$_6$O(OMe)$_{12}$Cl$_6$][NH$_2$Me$_2$]$_2$(MeOH)$_2$ | 12.5 | Irgacure® PAG 121 | 20.5 |
| [In$_6$O(OMe)$_{12}$Cl$_6$][NH$_2$Me$_2$]$_2$(MeOH)$_2$ | 12.5 | Tri-Ph-S$^+$, Triflat | 21.3 |
| [In$_6$O(OMe)$_{12}$Cl$_6$][NH$_2$Me$_2$]$_2$(MeOH)$_2$ | 12.5 | Di-Ph-I$^+$, NO$_3^-$ | 18 |
| Ga(acac)$_3$ | 25 | Irgacure® PAG 103 | 23.7 |

(fortgesetzt)

| Precursor | Konzentration Precursor [mg/ml] | Verwendeter PAG | Konzentration Precursor [mg/ml] |
|---|---|---|---|
| $Y_5O(O^iPr)_{13}$ | 7.5 | Irgacure® PAG 103 | 2 |
| $Ge(^iPrO)_4$ | 25 | Irgacure® PAG 103 | 28.2 |
| $In(NO_3)_3$ | 25 | Irgacure® PAG 103 | 29.0 |
| $InCl_3$ | 25 | Irgacure® PAG 103 | 39.4 |
| $Sn(^tBuO)_4$ | 25 | Irgacure® PAG 103 | 21.2 |
| $Zn(acac)_2$ | 25 | Irgacure® PAG 103 | 33.0 |

**Patentansprüche**

1.  Beschichtungszusammensetzung umfassend:

    a) mindestens einen Metalloxid-Prekursor,
    b) mindestens einen Photosäuregenerator und
    c) mindestens ein Lösemittel.

2.  Die Beschichtungszusammensetzung gemäß Anspruch 1, **dadurch gekennzeichnet, dass** der Metalloxid-Prekursor mindestens ein Metallatom ausgewählt aus der Gruppe bestehend aus In, Zn, Ga, Y, Sn, Ge, Sc, Ti, Zr, Al, W, Mo, Ni, Cr, Fe, Hf und Cu umfasst.

3.  Die Beschichtungszusammensetzung gemäß einem der Ansprüche 1 oder 2, **dadurch gekennzeichnet, dass** der mindestens eine Metalloxid-Prekursor mindestens einen Liganden ausgewählt aus der Gruppe bestehend aus Oxo-Resten, Hydroxyl-Resten, Alkoxy-Resten, Carboxy-Resten, β-Diketonat-Resten, Halogenid-Resten, Nitrat-Resten und sekundären und primären Amin-Resten umfasst.

4.  Die Beschichtungszusammensetzung gemäß einem der Ansprüche 1 bis 3, **dadurch gekennzeichnet, dass** der mindestens eine Photosäuregenerator unter Einwirkung von elektromagnetischer Strahlung in der Lage ist, ein oder mehrere Säuremoleküle freizusetzen.

5.  Die Beschichtungszusammensetzung gemäß Anspruch 3, **dadurch gekennzeichnet, dass** der mindestens eine Photosäuregenerator, bezogen auf die unter Einwirkung von elektromagnetischer Strahlung freisetzbaren Säuremoleküle, im mindestens äquimolaren Verhältnis zu dem mindestens einen Metalloxid-Prekursor in der Zusammensetzung enthalten ist.

6.  Die Beschichtungszusammensetzung gemäß einem der voranstehenden Ansprüche, **dadurch gekennzeichnet, dass** das mindestens eine Lösemittel ausgewählt ist aus der Gruppe bestehend aus β-Diketonen, Etheralkoholen, Alkoholen, Ethern und Estern.

7.  Verwendung der Beschichtungszusammensetzung gemäß einem der voranstehenden Ansprüche zur Herstellung direkt-strukturierter metalloxidischer Schichten.

8.  Verfahren zur Herstellung metalloxidischer Schichten, **dadurch gekennzeichnet, dass** das Verfahren die folgenden Schritte umfasst:

    (I) Beschichtung eines Substrates mit mindestens einer Beschichtungszusammensetzung gemäß einem der Ansprüche 1 bis 6;

(II) Belichtung der so aufgetragenen Beschichtung;

(III) Entwicklung der Beschichtung.

9. Das Verfahren gemäß Anspruch 8, **dadurch gekennzeichnet, dass** die Beschichtung des Substrats in Schritt (I) mittels eines Beschichtungsverfahrens ausgewählt aus der Gruppe bestehend aus Druckverfahren, Sprühverfahren, Rotationsbeschichtungsverfahren, Tauchverfahren und Verfahren ausgewählt aus Meniscus Coating, Slit Coating, Slot-Die Coating und Curtain Coating erfolgt.

10. Das Verfahren gemäß einem der Ansprüche 8 oder 9, **dadurch gekennzeichnet, dass** der Photosäuregenerator der Beschichtungszusammensetzung im Zuge der Belichtung in Schritt (II) Säuremoleküle freisetzt, die die Löslichkeit der Beschichtung ändern.

11. Das Verfahren gemäß einem der Ansprüche 8 bis 10, **dadurch gekennzeichnet, dass** die Belichtung in Schritt (II) mittels Bestrahlung mit UV-, IR- oder VIS-Strahlung erfolgt.

12. Das Verfahren gemäß einem der Ansprüche 8 bis 11, **dadurch gekennzeichnet, dass** die Entwicklung durch Behandlung mit mindestens einem Lösemittel ausgewählt aus der Gruppe bestehend aus wässrigen Basen, wässrigen Säuren, Wasser, Alkoholen, Ketonen, Estern sowie Mischungen der vorgenannten erfolgt.

13. Das Verfahren gemäß einem der Ansprüche 8 bis 12, **dadurch gekennzeichnet, dass** das Verfahren ferner einen Schritt (IV) der thermischen Konvertierung der entwickelten Beschichtung umfasst.

14. Metalloxid-haltige Schicht, hergestellt nach einem Verfahren gemäß einem der Ansprüche 8 bis 13.

15. Verwendung mindestens einer Metalloxid-haltigen Schicht nach Anspruch 14 zur Herstellung elektronischer Bauteile, insbesondere zur Herstellung von Transistoren, Dioden, Sensoren oder Solarzellen.

| Löslich im Entwickler | | Unlöslich im Enwickler | |
|---|---|---|---|
| Modifizierter Prekursor | $L_xM - Y$ | Unmodifizierter Prekursor | $L_xM - X$ |
| Photosäuregenerator | PAG | | |
| Generierte Säure | HX | | |
| Zerfallsprodukte des PAGs | PAG-Reste | | |

| Belichteter Bereich | Unbelichteter Bereich |
|---|---|
| Formulierung | Formulierung |
| $L_xM - Y$ + PAG + Lösungsmittel | $L_xM - Y$ + PAG + Lösungsmittel |
| ⬇ Beschichtung | ⬇ Beschichtung |
| Schicht | Schicht |
| $L_xM - Y$ + PAG | $L_xM - Y$ + PAG |
| ⬇ Belichtung | ⬇ Keine Belichtung |
| Chemische Reaktionen | keine Reaktionen |
| PAG ⇨ PAG-Reste + HX | $L_xM - Y$ + PAG |
| $L_xM - Y$ + HX ⇨ $L_xM - X$ + HY | |
| ⬇ Entwicklung | ⬇ Entwicklung |
| Keine Schicht | Schicht |
| | $L_xM - Y$ |

**Abb. 1**

**Abb. 2**

**Abb. 3**

Abb. 4

Abb. 5

Abb. 6

Abb. 7

**Abb. 8**

**Abb. 9**

Europäisches Patentamt

European Patent Office

Office européen des brevets

## EUROPÄISCHER RECHERCHENBERICHT

Nummer der Anmeldung

EP 17 15 5205

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 5 824 456 A (OGI KATSUMI [JP] ET AL) 20. Oktober 1998 (1998-10-20) * Ansprüche 1-18; Beispiele 17,41 * ----- | 1-15 | INV. C09D1/00 C23C18/14 G03F7/004 |
| X | DELLA GIUSTINA G ET AL: "Doubly patternable epoxy based sol-gel structures by UV and soft lithography", SOLID STATE SCIENCES, ELSEVIER, PARIS, FR, Bd. 12, Nr. 11, 1. November 2010 (2010-11-01), Seiten 1890-1893, XP027430311, ISSN: 1293-2558, DOI: 10.1016/J.SOLIDSTATESCIENCES.2010.04.016 [gefunden am 2010-04-27] * Seite 1891, linke Spalte, Absatz first - Seite 1892, linke Spalte, Absatz first; Abbildungen 1-3 * * Seite 1890, rechte Spalte, letzter Absatz * ----- | 1-15 | |
| X | CHRISTOPHER E. J. CORDONIER ET AL: "Photoacid Generating Ligands for Development of Positive-Tone Directly Photopatternable Metal Complexes", LANGMUIR, Bd. 27, Nr. 6, 15. März 2011 (2011-03-15), Seiten 3157-3165, XP055368729, US ISSN: 0743-7463, DOI: 10.1021/la104259f * schemes 1-5; paragraph "Patterning Procedure" on page 3161; Seite 3157, linke Spalte, Absatz first; Abbildungen 1-5 * ----- -/-- | 1-15 | RECHERCHIERTE SACHGEBIETE (IPC) C09D C23C G03F |

Der vorliegende Recherchenbericht wurde für alle Patentansprüche erstellt

| Recherchenort | Abschlußdatum der Recherche | Prüfer |
|---|---|---|
| München | 19. Mai 2017 | Schmitt, Johannes |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

................................................................
& : Mitglied der gleichen Patentfamilie, übereinstimmendes Dokument

EPO FORM 1503 03.82 (P04C03)

Seite 1 von 2

Europäisches
Patentamt

European
Patent Office

Office européen
des brevets

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DATABASE WPI<br>Week 200437<br>Thomson Scientific, London, GB;<br>AN 2004-393859<br>XP002770106,<br>-& JP 2004 045490 A (FUJI PHOTO FILM CO LTD) 12. Februar 2004 (2004-02-12)<br>* Zusammenfassung *<br>* Absätze [0031], [0093] - [0095], [0121], [0123]; Abbildung 1 *<br>----- | 1-15 | |

RECHERCHIERTE
SACHGEBIETE (IPC)

Der vorliegende Recherchenbericht wurde für alle Patentansprüche erstellt

| Recherchenort | Abschlußdatum der Recherche | Prüfer |
|---|---|---|
| München | 19. Mai 2017 | Schmitt, Johannes |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument

......................................................................
& : Mitglied der gleichen Patentfamilie, übereinstimmendes
Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 17 15 5205

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

19-05-2017

| Im Recherchenbericht angeführtes Patentdokument | Datum der Veröffentlichung | Mitglied(er) der Patentfamilie | Datum der Veröffentlichung |
|---|---|---|---|
| US 5824456 A | 20-10-1998 | US 5637440 A<br>US 5824456 A | 10-06-1997<br>20-10-1998 |
| JP 2004045490 A | 12-02-2004 | KEINE | |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 07258866 A

- DE 102013212018 A1

**In der Beschreibung aufgeführte Nicht-Patentliteratur**

- **CORDONIER et al.** *Langmuir,* 2011, vol. 27 (6), 3157-3165

- **RIM et al.** *ACS Nano,* 2014, vol. 8 (9), 9680-9686